# EUROPEAN PATENT APPLICATION

(11) **EP 2 372 683 A1**
(43) Date of publication of application: **05.10.2011**
(21) Application number: 10196578.8
(22) Date of filing: 22.12.2010
(51) Int. Cl.: G09G 3/32

(54) **Pixel and organic light emitting display including the same**

(30) Priority: 16.03.2010 KR 20100023343
(71) Applicant: Samsung Mobile Display Co., Ltd., Yongin-city, Gyunggi-do 446-711 (KR)
(72) Inventor: Bae, Han-Sung, Chungcheongnam-do (KR); Baek, Ji-Won, Chungcheongnam-do (KR); Kwak, Won-Kyu, Chungcheongnam-do (KR)
(74) Representative: Walaski, Jan Filip

(57) **Abstract**

A pixel includes an organic light emitting diode (OLED) coupled between first and second power sources (ELVDD,ELVSS), and a pixel circuit coupled between the first power source and the OLED to control driving current supplied to the OLED. The pixel circuit includes a first transistor (T1) with a first electrode coupled to a data line (Dm), a second electrode coupled to a first node (N1), and a gate electrode coupled to a current scan line (Sn), a second transistor (T2) with a first electrode coupled to the first power source via the first node, a second electrode coupled to the OLED, and a gate electrode coupled to a second node (N2), a first capacitor (C1) coupled between the first power source and the second node, and a second capacitor (C2) coupled between the second node and the current scan line. An aperture is formed in at least one electrode of the two electrodes of the first capacitor.

## Description

The present invention relates to a pixel and an organic light emitting display including the same, and more particularly, to a pixel capable of displaying an image with uniform picture quality and an organic light emitting display including the same.

An organic light emitting display displays an image using organic light emitting diodes (OLED) as self-emission elements. The organic light emitting display may be made thin and has high brightness and color purity. Thus, the organic light emitting display has attracted attention as a next generation display.

A pixel of the organic light emitting display includes an OLED and a pixel circuit. The pixel circuit supplies a driving current corresponding to a data signal to the OLED. The pixel circuit includes a switching transistor, a storage capacitor, and a driving transistor. The switching transistor transmits a data signal from a data line to the inside of a pixel to correspond to a scan signal supplied from a scan line. The storage capacitor stores the data signal. The driving transistor supplies a driving current corresponding to the data signal to the OLED.

The above-described pixel may not sufficiently display desired brightness due to voltage drop caused by a load on a panel. For example, when a black gray scale is to be displayed, the gate voltage of the driving transistor may not sufficiently increase so that contrast ratio may be reduced. Therefore, in order to prevent the contrast ratio from being reduced, a pixel structure that additionally adopts a boosting capacitor is provided.

In the pixel that adopts the boosting capacitor, charge sharing is generated between the storage capacitor and the boosting capacitor. Thus, the brightness of the pixel varies with the capacitance ratios of the storage capacitor and the boosting capacitor. Therefore, in order to prevent a brightness deviation between pixels and to display an image with uniform picture quality, it is important to maintain uniform capacitance ratios of the storage capacitor and the boosting capacitor.

However, the capacitance ratios of the storage capacitor and the boosting capacitor may change due to process deviation generated in manufacturing processes. Since the capacitances of the storage capacitor and the boosting capacitor are set to be different, the degrees of change are different. Thus, the capacitance ratios of the storage capacitor and the boosting capacitor are easily changed. Therefore, picture quality may become non-uniform.

Accordingly, aspects of the present invention provide a pixel capable of displaying an image with uniform picture quality regardless of the process deviation of the capacitors included in pixels and an organic light emitting display including the same.

According to an aspect of the present invention, there is provided a pixel includes an organic light emitting diode (OLED) coupled between a first power source and a second power source and a pixel circuit coupled between the first power source and the OLED to control driving current supplied to the OLED. The pixel circuit includes a first transistor whose first electrode is coupled to a data line, whose second electrode is coupled to a first node, and whose gate electrode is coupled to a current scan line, a second transistor whose first electrode is coupled to the first power source via the first node, whose second electrode is coupled to the OLED, and whose gate electrode is coupled to a second node, a first capacitor coupled between the first power source and the second node, and a second capacitor coupled between the second node and the current scan line. In a region where two electrodes of the first capacitor overlap each other, an aperture is formed in at least one electrode of the two electrodes of the first capacitor.

According to an aspect of the invention, the capacitance of the first capacitor is set to be larger than the capacitance of the second capacitor.

According to an aspect of the invention, the first capacitor includes a first electrode including a first conductive layer coupled to the first power source and positioned in the same layer as a gate electrode of the first and second transistors and a second electrode including a semiconductor layer coupled to the second node and positioned in the same layer as an activation layer of the first and second transistors.

According to an aspect of the invention, the semiconductor layer that constitutes the second electrode of the first capacitor includes the aperture formed in a region overlapping the first conductive layer.

According to an aspect of the invention, a plurality of the apertures are formed in at least one electrode of the two electrodes of the first capacitor.

According to an aspect of the invention, the pixel circuit includes a third transistor whose first electrode is coupled to a second electrode of the second transistor, whose second electrode is coupled to the second node, and whose gate electrode is coupled to the current scan line, a fourth transistor whose first electrode is coupled to the first power source, whose second electrode is coupled to the first node, and whose gate electrode is coupled to an emission control line, a fifth transistor whose first electrode is coupled to the second electrode of the second transistor, whose second electrode is coupled to the OLED, and whose gate electrode is coupled to the emission control line, and a sixth transistor whose first electrode is coupled to the second node, whose second electrode is coupled to an initialize power source, and whose gate electrode is coupled to a previous scan line.

According to an aspect of the present invention, an organic light emitting display includes a plurality of pixels positioned at intersections between scan lines and data lines so that each of the pixels includes an OLED coupled between a first power source and a second power source and a pixel circuit coupled between the first power source and the OLED to control driving current supplied to the OLED. The pixel circuit includes a first transistor whose first electrode is coupled to a data line, whose second electrode is coupled to a first node, and whose gate electrode is coupled to a current scan line, a second transistor whose first electrode is coupled to the first power source via the first node, whose second electrode is coupled to the OLED, and whose gate electrode is coupled to a second node, a first capacitor coupled between the first power source and the second node, and a second capacitor coupled between the second node and the current scan line. In a region where two electrodes of the first capacitor overlap each other, an aperture is formed in at least one electrode of the two electrodes of the first capacitor.

According to an aspect of the present invention, the capacitance ratios of the first capacitor and the second capacitor in each of the pixels are set to be uniform.

According to an aspect of the present invention, the capacitance of the first capacitor is set to be larger than capacitance of the second capacitor.

In the pixel according to aspects of the present invention and the organic light emitting display including the same, an aperture is formed in a storage capacitor having larger capacitance than a boosting capacitor so that the capacitance change degrees of the boosting capacitor and the storage capacitor caused by a process deviation are controlled to be similar.

Aspects of the present invention have the capacitance ratios of the storage capacitor and the boosting capacitor maintained to be uniform so that an image with uniform picture quality may be displayed regardless of the process deviation between the capacitors included in the pixels.

According to another aspect of the invention, there is provided a pixel circuit to control a driving current supplied to an organic light emitting diode (OLED) coupled to a power source, the pixel circuit comprising a first node to be coupled to the power source, a first transistor having a first electrode to be coupled to a data line, a second electrode coupled to the first node, and a gate electrode to be coupled to a scan line, a second node, a second transistor having a first electrode coupled to the first node, a second electrode to be coupled to the OLED, and a gate electrode coupled to the second node, a first capacitor coupled to the second node and to be coupled to the power source using first and second capacitor electrodes having a shaping element at a region where the first capacitor electrode overlaps the second capacitor electrode and a second capacitor coupled to the second node and to be coupled to the scan line, wherein the shaping element shapes the first and/or second capacitor electrodes to control a capacitance ratio of the first and second capacitors to be a predetermined value.

The shaping element may comprise an opening extending through one of the first and second capacitor electrodes.

The shaping element comprises a plurality of openings extending through one of the first and second capacitor electrodes.

Additional aspects and/or advantages of the invention will be set forth in part in the description which follows and, in part, will be obvious from the description, or may be learned by practice of the invention.

These and/or other aspects and advantages of the invention will become apparent and more readily appreciated from the following description of the embodiments, taken in conjunction with the accompanying drawings of which:
FIG. 1 is a block diagram schematically illustrating the structure of an organic light emitting display according to an embodiment of the present invention;
FIG. 2 is a circuit diagram illustrating an example of the pixel of FIG. 1;
FIG. 3 is a waveform chart illustrating the driving signals of the pixel of FIG. 2; and
FIG. 4 is a plan view illustrating an example of the layout of the pixel circuit of FIG. 2.

Reference will now be made in detail to the present embodiments of the present invention, examples of which are illustrated in the accompanying drawings, wherein like reference numerals refer to the like elements throughout. The embodiments are described below in order to explain the present invention by referring to the figures.

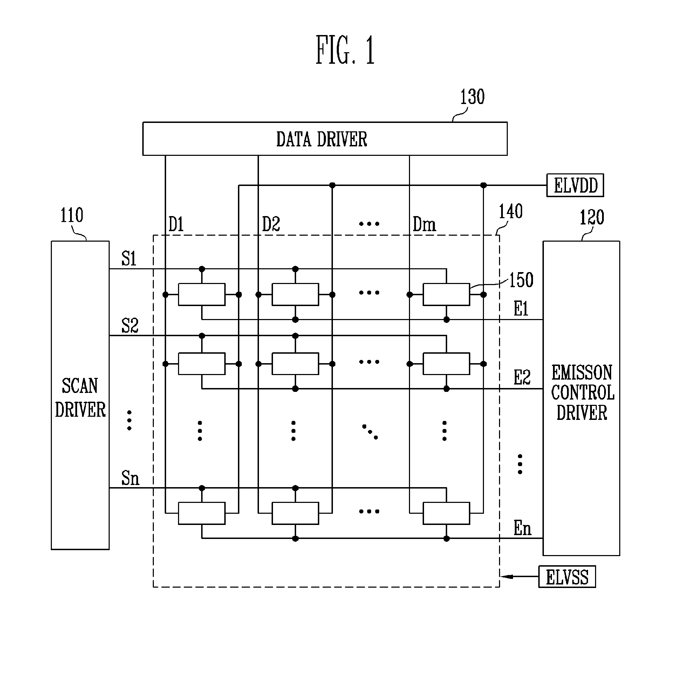

FIG. 1 is a block diagram schematically illustrating the structure of an organic light emitting display according to an embodiment of the present invention. Referring to FIG. 1, the organic light emitting display includes a scan driver 110, an emission control driver 120, a data driver 130, and a pixel unit 140.

The scan driver 110 sequentially supplies scan signals to scan lines S1 to Sn to correspond to control signals supplied from an external control circuit (not shown) (for example, a timing controller). Then, pixels 150 are selected by the scan signals to sequentially receive data signals from data lines D1 through Dm.

The emission control driver 120 sequentially supplies emission control signals to emission control lines E1 to En to correspond to the control signals supplied from the external control unit. The emission of the pixels 150 is controlled by the emission control signals. That is, the emission control signals control the emission time of the pixels 150. The emission control driver 120 may be omitted in accordance with the internal structure of the pixels 150.

The data driver 130 supplies the data signals to the data lines D1 to Dm to correspond to the control signals supplied from the external control circuit. The data signals supplied to the data lines D1 to Dm are supplied to the selected pixels 150 by the scan signals whenever the scan signals are supplied. Then, the pixels 150 charge voltages corresponding to the data signals and emit light with brightness components corresponding to the voltages.

The pixel unit 140 includes the plurality of pixels 150 positioned at the intersections of the emission control lines E1 to En and the data lines D1 to Dm. Here, each of the pixels 150 includes an organic light emitting diode (not shown) that emits light with brightness corresponding to driving current corresponding to the data signal and a pixel circuit (not shown) for controlling driving current that flows through the OLED.

The pixel unit 140 receives a first power source (for example, a high potential pixel power source, ELVDD) and a second power source (for example, a low potential pixel power source, ELVSS) from the outside. The first power source ELVDD and the second power source ELVSS are transmitted to each of the pixels 150. Then, the pixels 150 emit light with the brightness components corresponding to the driving currents that flow from the first power source ELVDD to the second power source ELVSS via the OLED to correspond to the data signals.

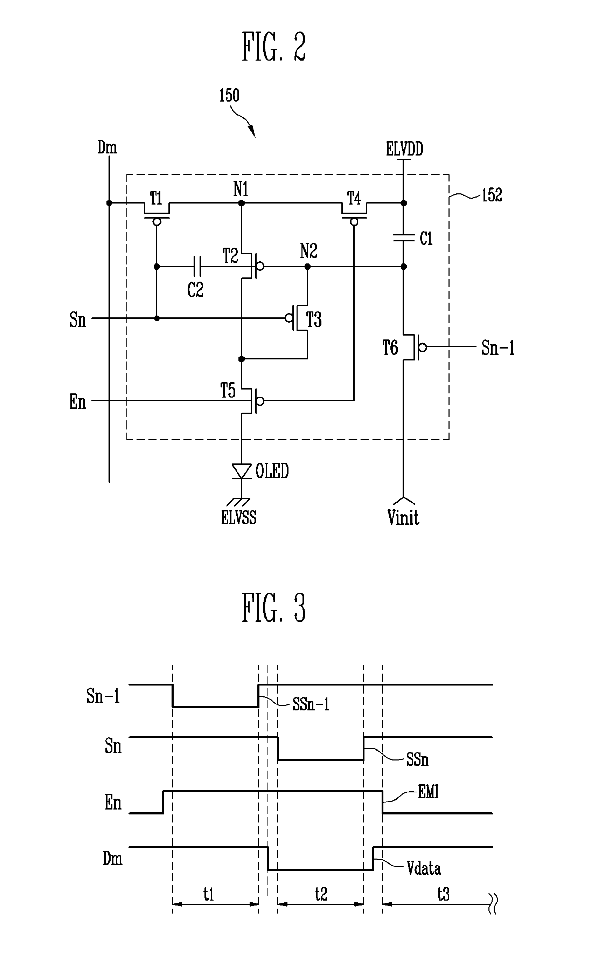

FIG. 2 is a circuit diagram illustrating an example of the pixel 150 of FIG. 1. FIG. 3 is a waveform chart illustrating the driving signals of the pixel of FIG. 2. First, referring to FIG. 2, the pixel 150 includes an OLED coupled between the first power source ELVDD and the second power source ELVSS. A pixel circuit 152 is coupled between the first power source ELVDD and the OLED to control the driving current supplied to the OLED.

In detail, the anode electrode of the OLED is coupled to the first power source ELVDD that is a high potential pixel power source via the pixel circuit 152 and the cathode electrode of the OLED is coupled to the second power source ELVDD that is a low potential pixel power source. The OLED emits light with brightness corresponding to the driving current when the driving current is supplied from the pixel circuit 152.

The pixel circuit 152 includes first to sixth transistors T1 to T6 and first and second capacitors C1 and C2. The first transistor T1 transmits the data signal supplied from the data line Dm to the inside of the pixel 150 when the current scan signal is supplied from the current scan line Sn. That is, the first transistor T1 functions as the switching transistor of the pixel 150. The first electrode of the first transistor T1 is coupled to the data line Dm and the second electrode of the first transistor T1 is coupled to a first node N1 in the pixel 150. Here, the first electrode and the second electrode are different electrodes. For example, when the first electrode is set as a source electrode, the second electrode is set as a drain electrode. The gate electrode of the first transistor T1 is coupled to the current scan line Sn.

The second transistor T2 supplies the driving current corresponding to the data signal from the first power source ELVDD to the OLED in the emission period of the pixel 150. That is, the second transistor T2 functions as the driving transistor of the pixel 150. The first electrode of the second transistor T2 is coupled to the first power source ELVDD via the first node N1 and the fourth transistor T4. The second electrode of the second transistor T2 is coupled to the OLED via the fifth transistor T5. The gate electrode of the second transistor T2 is coupled to a second node N2 to which one electrode of the first capacitor C1 for storing the data signal is coupled.

The third transistor T3 compensates the threshold voltage of the second transistor T2 and couples the second transistor T2 in the form of a diode when the data signal is supplied to the inside of the pixel 150. Therefore, the first electrode of the third transistor T3 is coupled to the second electrode of the second transistor T2 and the second electrode of the third transistor T3 is coupled to the second node N2 to which the gate electrode of the second transistor T2 is coupled. The gate electrode of the third transistor T3 is coupled to the current scan line Sn.

The fourth transistor T4 blocks coupling between the first power source ELVDD and the second transistor T2 in the non-emission period of the pixel 150 and couples the first power source ELVDD and the second transistor T2 to each other in the emission period of the pixel 150 to form a current path through which the driving current flows. Therefore, the first electrode of the fourth transistor T4 is coupled to the first power source ELVDD and the second electrode of the fourth transistor T4 is coupled to the first node N1 to which the first electrode of the second transistor T2 is coupled. The gate electrode of the fourth transistor T4 is coupled to the emission control line En to which an emission control signal for controlling the emission period of the pixel 150 is input.

The fifth transistor T5 blocks coupling between the second transistor T2 and the OLED in the non-emission period of the pixel 150 and couples the second transistor T2 to the OLED in the emission period of the pixel 150 to form a current path through which the driving current flows. Therefore, the first electrode of the fifth transistor T5 is coupled to the second electrode of the second transistor T2 and the second electrode of the fifth transistor T5 is coupled to the anode electrode of the OLED. The gate electrode of the fifth transistor T5 is coupled to the emission control line En.

The sixth transistor T6 initializes the second node N2 in an initialize period before a data programming period so that the data signal may be smoothly supplied to the inside of the pixel 150 in the data programming period where the data signal is input to the pixel 150. Therefore, the first electrode of the sixth transistor T6 is coupled to the second node N2 and the second electrode of the sixth transistor T6 is coupled to an initialize power source Vinit. The gate electrode of the sixth transistor T6 is coupled to a previous scan line Sn-1 to which a previous scan signal was supplied.

The first capacitor C1 stores the data signal supplied to the inside of the pixel 150 in the data programming period and maintains the data signal in one frame. The first capacitor C1 is coupled between the first power source ELVDD and the second node N2. That is, the first capacitor C1 functions as the storage capacitor. The first electrode of the first capacitor C1 is coupled to the first power source ELVDD and the second electrode of the first capacitor C1 is coupled to the second node N2.

The second capacitor C2 compensates for a voltage drop caused by a load in a panel to improve a contrast ratio. The second capacitor C2 is coupled between the current scan line Sn and the second node N2. That is, the second capacitor C2 increases the voltage of the second node N2 by a coupling operation when the voltage level of the current scan signal changes, in particular, at the point of time where supply of the current scan signal is stopped to function as a boosting capacitor for compensating for the voltage drop caused by the load in the panel. Therefore, the first electrode of the second capacitor C2 is coupled to the current scan line Sn and the second electrode of the second capacitor C2 is coupled to the second node N2.

Hereinafter, the operation of the above-described pixel 150 will be described in detail with reference to the driving waveform illustrated in FIG. 3 in connection with FIG. 2. Referring to FIG. 3, in a first period t1 set as the initialize period, a previous scan signal SSn-1 in a low level is supplied through the previous scan line Sn-1. Then, the sixth transistor T6 is turned on to correspond to the previous scan signal SSn-1 in the low level. Therefore, the voltage of the initialize power source Vinit is transmitted to the second node N2. Here, the voltage of the initialize power source Vinit may be set to have a value that may initialize the pixel 150, for example, a value no more than the value of the lowermost voltage of the data signal Vdata.

Then, in a second period t2 set as the data programming period, a current scan signal SSn in a low level is supplied through the current scan line Sn. Then, the first and third transistors T1 and T3 are turned on to correspond to the current scan signal SSn in the low level. The second transistor T2 is turned on to be coupled in the form of a diode by the third transistor T3. In particular, since the second node N2 is initialized in the previous first period t1, the second transistor T2 is coupled in the form of a diode in a forward direction.

Therefore, the data signal Vdata supplied to the data line Dm is supplied to the second node N2 via the first to third transistors T1 to T3. At this time, since the second transistor T2 is coupled in the form of a diode, a voltage corresponding to a difference between the data signal Vdata and the second transistor T2 is supplied to the second node N2. The voltage supplied to the second node N2 is stored in the first capacitor C1.

Then, when supply of the current scan signal SSn is stopped and the voltage level of the current scan signal SSn is transited to a high level, the voltage of the second node N2 changes to correspond to the voltage change width of the current scan signal SSn due to the coupling operation of the second capacitor C2. At this time, since the voltage of the second node N2 changes due to charge sharing between the first capacitor C1 and the second capacitor C2, the voltage change amount of the second node N2 changes in proportion to a charge sharing value between the first and second capacitors C1 and C2 with the voltage change width of the current scan signal SSn.

Then, the emission control signal EMI supplied from the emission control line En in a third period t3 set as an emission period is transited from a high level to a low level. Then, in the third period t3, the fourth and fifth transistors T4 and T5 are turned on by the emission control signal EMI in the low level. Therefore, the driving current flows from the first power source ELVDD to the second power source ELVSS via the fourth transistor T4, the second transistor t2, the fifth transistor T5, and the OLED.

The driving current is controlled by the second transistor T2. The second transistor T2 generates the voltage supplied to the gate electrode thereof, that is, the driving current of the magnitude corresponding to the voltage of the second node N2.

At this time, since a voltage to which the threshold voltage of the second transistor T2 is reflected is stored in the first capacitor C1 in the second period t2, the threshold voltage of the second transistor T2 is compensated for in the third period t3.

Furthermore, since the voltage of the second node N2 changes in accordance with the charge sharing value between the first and second capacitors C1 and C2 together with the voltage change width of the current scan signal SSn when the supply of the current scan signal SSn stops, in order to prevent a brightness deviation among the pixels 150 and to display an image with uniform picture quality, it is important to maintain the capacitance ratios of the first capacitor C1 and the second capacitor C2 to be uniform.

As such, according to an aspect of the present invention, the first capacitor C1 is designed to have enough capacitance to stably store the data signal in the data programming period. Further, the second capacitor C2 is set to have enough capacitance to provide a voltage boosting effect. The second capacitor C2 is designed to have a smaller capacitance than a capacitance of the first capacitor C1. For example, the first capacitor C1 may be designed to have a capacitance of no less than five times the second capacitor C2. However, the relative capacitances are not specifically so limited.

Therefore, the areas and positions of the first capacitor C1 and the second capacitor C2 are changed due to the process deviation generated in manufacturing processes so that the sensitivity and degree of change of generated capacitance vary. Specifically, in the case of the second capacitor C2 designed to have the small capacitance, the capacitance change ratio caused by the process deviation is larger than the capacitance change ratio of the first capacitor C1. Therefore, the capacitance ratios of the first capacitor C1 and the second capacitor C2 are changed.

As described above, when the capacitance ratios of the first capacitor C1 and the second capacitor C2 are changed, the brightness deviation is generated among pixels 150 so that picture quality may be non-uniform. Therefore, aspects of the present invention are designed to improve the above-described picture quality nonuniformity. There is provided a pixel 150 capable of displaying an image with uniform picture quality by forming an aperture in the first capacitor C1 whose capacitance change ratio was caused by the process deviation is smaller so that the capacitance change degree caused by the process deviation of the first capacitor C1 is controlled to be similar to or the same as the capacitance change degree of the second capacitor C2 to maintain the capacitance ratios of the first capacitor C1 and the second capacitor C2 regardless of the process deviation and an organic light emitting display including the same.

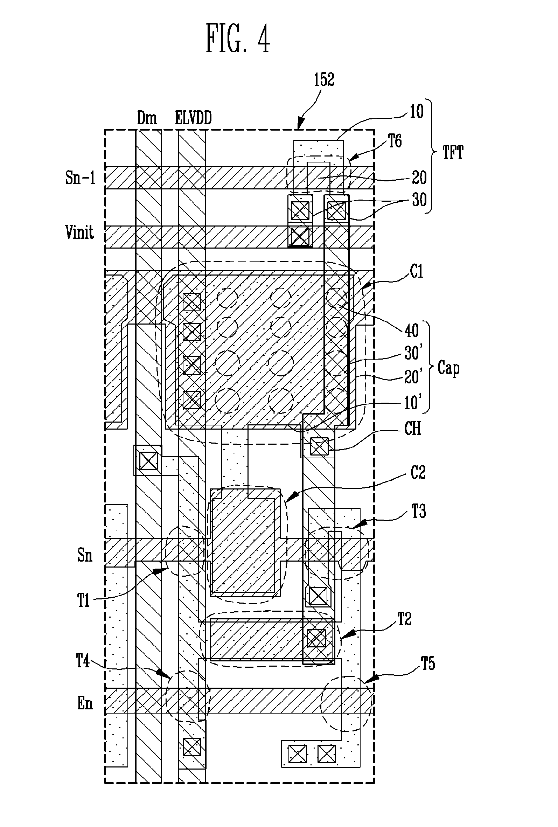

Therefore, the first capacitor C1 according to an aspect of the present invention includes the aperture formed in at least one electrode in a region where two electrodes of the first capacitor C1 overlap each other. Detailed description thereof will be described with reference to FIG. 4.

The pixel 150 described above with reference to FIGs. 2 and 3 is a pixel formed in one embodiment and the present invention is not limited to the structure of the above described pixel 150. For example, at least one of the third transistor T3 for compensating for the threshold voltage of the second transistor T2, the fourth and fifth transistors T4 and T5 for controlling the emission period, and the sixth transistor T6 for initialization may be omitted or the coupling relationships and driving waveforms of the third to sixth transistors T3 to T6 may be changed.

That is, the present invention may be applied to various kinds of pixel structures that are currently made public. In particular, the present invention may be usefully applied when the capacitance ratios of the capacitors are to be uniformly maintained in a structure where at least two capacitors (that is, the first and second capacitors C1 and C2) that affect the gate voltage of the driving transistor (that is, the second transistor T2) are provided.

FIG. 4 is a plan view illustrating an example of the layout of the pixel circuit 152 of FIG. 2. FIG. 4 illustrates a characteristic of an aspect of the present invention: the aperture 40 formed in the first capacitor C1. Illustration of partial components (for example, the OLED formed on the pixel circuit) that are not essential to describing the characteristic of the present invention will be omitted.

Referring to FIG. 4, the first to sixth transistors T1 to T6 include a semiconductor layer 10 including an activation layer, a gate electrode 20 arranged to overlap at least one region of the semiconductor layer 10 and formed of a gate metal, and source and drain electrodes 30 coupled to the activation layer and formed of source and drain metals.

The first and second capacitors C1 and C2 include a semiconductor layer 10' positioned in the same layer as the activation layer of the first to sixth transistors T1 to T6, a first conductive layer 20' positioned in the same layer as the gate electrode 20 of the first to sixth transistor T1 to T6, and a second conductive layer 30' positioned in the same layer as the source and drain electrodes 30 of the first to sixth transistors T1 to T6. Here, CH denotes a contact hole.

The above is only an example. The structures of the first to sixth transistors T1 to T6 and the first and second capacitors C1 and C2 may be changed. For example, in partial transistors among the first to sixth transistors T1 to T6, the source and/or drain electrodes are formed of the semiconductor layer 10 integrated with the active layer instead of the source and drain metals and may be integrated with the active layer of the transistor coupled thereto.

Since the active layer of the first to sixth transistors T1 to T6 is formed in the semiconductor layer 10 in the region that overlaps the gate electrode 20, for convenience sake, in FIG. 4, the positions of the first to sixth transistors T1 to T6 are remarked based on the region where the activation layer is formed.

Also, the first and second capacitors C1 and C2 are formed by overlapping at least two of the semiconductor layers 10' positioned in the same layer as the activation layer of the first to sixth transistors T1 to T6, the first conductive layer 20' positioned in the same layer as the gate electrode 20 of the first to sixth transistors T1 to T6, and the second conductive layer 30' positioned in the same layer as the source and drain electrodes 30 of the first to sixth transistors T1 to T6.

In particular, FIG. 4 illustrates an example in which most of the capacitance of the first and second capacitors C1 and C2 is formed by the semiconductor layer 10' and the first conductive layer 20'. The first capacitor C1 includes the semiconductor layer 10' and the first conductive layer 20' that almost entirely overlap each other, and the second conductive layer 30' that partially overlaps the semiconductor layer 10' and the first conductive layer 20' in the overlapping region. The second capacitor C2 includes the semiconductor layer 10' and the second conductive layer 30' that almost entirely overlap.

However, the present invention is not limited to the example described in FIG. 4. For example, in other aspects, the first and second capacitors C1 and C2 may be realized by entirely overlapping the first conductive layer 20' and the second conductive layer 30'.

While not required in all aspects, the first and second capacitors C1 and C2 may be simultaneously formed while forming the first to sixth transistors T1 to T6 as an example for improving the efficiency of manufacturing processes. Therefore, the semiconductor layer 10' of the first and second capacitors C1 and C2 may be formed in forming the activation layer of the first to sixth transistors T1 to T6 using the same material in the same layer. The first conductive layer 20' of the first and second capacitors C1 and C2 can be formed while forming the gate electrode 20 of the first to sixth transistors T1 to T6 using the same material (that is, the gate metal) in the same layer. The second conductive layer 30' of the first and second capacitors C1 and C2 is formed in forming the source and drain electrodes 30 of the first to sixth transistors T1 to T6 using the same material (that is, the source and drain metals) in the same layer. However, aspects of the invention are not limited to the above formation methods.

According to an aspect of the present invention, the first capacitor C1 includes the aperture 40 formed in at least one electrode of two electrodes in the region where the two electrodes overlap each other. For example, when the first capacitor C1 includes a first electrode having the first conductive layer 20' coupled to the first power source ELVDD and positioned in the same layer as the gate electrode of the first to sixth transistors T1 to T6 and a second electrode having the semiconductor layer 10' coupled to the second node N2 of FIG. 2 and positioned in the same layer as the activation layer of the first to sixth transistors T1 to T6, at least one aperture 40 may be formed in at least one of the semiconductor layer 10' and the first conductive layer 20' of the first capacitor C1.

When the aperture 40 is formed in the semiconductor layer 10' having smaller process deviation than the first conductive layer 20', the position or size of the aperture 40 may be easily controlled. That is, according to an aspect of the present embodiment, the aperture 40 is formed in the region that overlaps the first conductor layer 20' of the semiconductor layer 10' that constitutes the second electrode of the first capacitor C1.

However, the present invention is not limited to the above. The aperture 40 may be formed in at least one of the semiconductor layer 10', the first conductive layer 20', and the second conductive layer 30'.

The aperture 40 controls the capacitance change ratio of the first capacitor C1 caused by the process deviation to be sensitive to a degree similar to or the same as the capacitance change ratio of the second capacitor C2 to maintain the capacitance ratios of the first capacitor C1 and the second capacitor C2 to be uniform regardless of the process deviation and to display an image with uniform picture quality. While not required in all aspects, the capacitance reduction amount of the first capacitor C1 caused by the aperture 40 may be compensated for by expanding the outline of the first capacitor C1.

Therefore, the process deviation between the first capacitor C1 and the second capacitor C2 that is previously grasped through test deposition or simulation is reflected to control the area and position of the aperture 40 and the number of apertures 40 so that the capacitance ratios of the first capacitor C1 and the second capacitor C2 of each of the pixels become uniform (that is, become the same in a predetermined error range).

In addition, while not required in all aspects, in the shown example, a plurality of apertures 40 are formed in at least one electrode of the two electrodes of the first capacitor C1 so that the capacitance change degree of the first capacitor C1 may be easily controlled. While depicted as round, it is understood that the invention is not limited to a particular shape of the aperture 40. Further, while shown as being in a central area of the electrode, it is understood that the aperture 40 can also extend to an edge of the electrode so as to form a notch in the electrode in addition to or instead of being entirely surrounded by the electrode.

As described above, according to an aspect of the present invention, the aperture 40 is formed in the storage capacitor (such as the first capacitor C1) having a larger capacitance than the boosting capacitor (such as the second capacitor C2) so that the capacitance change degrees of the boosting capacitor and the storage capacitor caused by the process deviation may be controlled to be similar to each other. Therefore, the capacitance ratios of the storage capacitor and the boosting capacitor are maintained to be uniform so that an image with uniform picture quality may be displayed regardless of the process deviation between the capacitors included in the pixels according to aspects of the invention.

Although a few embodiments of the present invention have been shown and described, it would be appreciated by those skilled in the art that changes may be made in this embodiment without departing from the principles of the invention, the scope of which is defined in the claims.

## Claims

1. A pixel comprising:
an organic light emitting diode (OLED) coupled between a first power source and a second power source; and
a pixel circuit coupled between the first power source and the OLED to control a driving current supplied to the OLED, the pixel circuit comprising:
a first transistor having a first electrode coupled to a data line, a second electrode coupled to a first node, and a gate electrode coupled to a current scan line;
a second transistor having a first electrode coupled to the first power source via the first node, a second electrode coupled to the OLED, and a gate electrode coupled to a second node;
a first capacitor coupled between the first power source and the second node using first and second capacitor electrodes; and
a second capacitor coupled between the second node and the current scan line,
wherein an aperture is formed in at least one of the first and second capacitor electrodes in a region where the first and second capacitor electrodes overlap.

2. The pixel as claimed in claim 1, wherein a capacitance of the first capacitor is larger than a capacitance of the second capacitor.

3. The pixel as claimed in claim 1 or 2, wherein:
the first capacitor electrode includes a first conductive layer coupled to the first power source and positioned on the same layer as the gate electrodes of the first and second transistors; and
the second capacitor electrode includes a semiconductor layer coupled to the second node and positioned on the same layer as an activation layer of the first and second transistors.

4. The pixel as claimed in claim 3, wherein the semiconductor layer of the second capacitor electrode comprises the aperture.

5. The pixel as claimed in any one of the preceding claims, wherein the aperture is one of a plurality of apertures formed on the at least one of the first and second capacitor electrodes.

6. The pixel as claimed in any one of the preceding claims, wherein the pixel circuit further comprises:
a third transistor having a first electrode coupled to the second electrode of the second transistor, a second electrode coupled to the second node, and a gate electrode coupled to the current scan line;
a fourth transistor having a first electrode coupled to the first power source, a second electrode coupled to the first node, and a gate electrode coupled to an emission control line;
a fifth transistor having a first electrode coupled to the second electrode of the second transistor, a second electrode coupled to the OLED, and a gate electrode coupled to the emission control line; and
a sixth transistor having a first electrode coupled to the second node, a second electrode coupled to an initialize power source, and a gate electrode coupled to a previous scan line.

7. An organic light emitting display comprising:
scan lines extending in a first direction;
data lines extending in a second direction crossing the first direction; and a plurality of pixels positioned at intersections between the scan lines and the data lines, each of the pixels comprising a pixel according to any one of the preceding claims.

8. The organic light emitting display device as claimed in claim 7, wherein capacitance ratios of the first capacitor and the second capacitor in each of the pixels are set to be uniform.

9. The organic light emitting display device as claimed in claim 8, wherein the size and/or position of the aperture in at least one of the first and second capacitor electrodes is set to control the capacitance ratios of the first and second capacitors to be a predetermined value.

10. The organic light emitting display device as claimed in any one of claims 7 to 9, wherein the outline of the first capacitor is arranged to be expanded to compensate for a capacitance reduction due to the presence of the aperture.
